Europäisches Patentamt

European Patent Office

Office européen des brevets

(11) Publication number: **0 091 733**
A1

## (12) EUROPEAN PATENT APPLICATION

(21) Application number: **83301309.7**

(51) Int. Cl.³: **H 05 K 7/20**

(22) Date of filing: **09.03.83**

(30) Priority: **09.03.82 GB 8206823**

(43) Date of publication of application:
**19.10.83 Bulletin 83/42**

(84) Designated Contracting States:
**AT BE CH DE FR IT LI LU NL SE**

(71) Applicant: BICC-Vero Electronics Limited
Parr, St. Helens
Merseyside, WA9 1PR(GB)

(72) Inventor: Bell, David Leslie
246 Springvale Road Kingsworthy
Winchester Hampshire(GB)

(74) Representative: Ross Gower, Edward Lewis et al,
BICC Public Limited Company 38 Ariel Way Wood Lane
London W12 7DX(GB)

(54) Cooling module for use in a circuit board array.

(57) In a circuit board installation in which circuit boards 24 are slidably mounted in opposed guide rails 22 of a rack 21 in a cabinet 20, an efficient and relatively inexpensive flat cooling module 1 is slidably mounted in opposed guide rails between two circuit boards. The cooling module 1 comprises a pair of flat side walls 2 spaced apart and sealed together around their edges to form a sealed chamber 6, an inlet port (not shown) connected to a source of pressurised cooling fluid and, in each of the side walls, mutually spaced orifices 12, in which nipples 14 may be fitted, through which pressurised cooling fluid is directed towards components 25 of the adjacent circuit boards 24.

./...

Croydon Printing Company Ltd.

Fig.2

0091733

AN IMPROVED CIRCUIT BOARD INSTALLATION

This invention relates to cabinets, cases and other enclosures including racks for accommodating circuit boards. Such racks generally comprise pairs of opposed guide rails into which edges of a circuit board can be slid from the front of the rack and edge connectors at the rear of the rack which co-operate with connectors mounted on the rear edges of circuit boards that have been slid into opposed guide rails of the rack. A cabinet or other enclosure including a rack accommodating circuit boards will hereinafter, for convenience, be referred to as a "circuit board installation of the kind described".

The development of silicon chips has resulted in a substantial increase in the component density of individual circuit boards of a circuit board installation of the kind described and the increased component density of each circuit board of the installation has resulted in a greater power output and hence higher operating temperatures.

Conventional methods of controlling the temperature of the enclosure of a circuit board installation of the kind described include normal convection, forced convection, e.g. fan cooling, liquid cooling, various forms of heat sink, and a combination of two or more of these methods but all of these known methods are unsatisfactory because they are inefficient and/or expensive to operate.

It is an object of the present invention to provide, in a circuit board installation of the kind described, an improved cooling system which is efficient and avoids wastage of space within the enclosure of the installation.

In the improved circuit board installation in accordance with the invention, at least one substantially flat cooling module is slidably mounted in opposed guide rails of the rack adjacent a circuit board or circuit boards, which cooling module comprises a pair of substantially flat side walls spaced apart and sealed together around their peripheral edges to form a sealed chamber, at least one inlet port connected or adapted to be connected to a source of pressurised cooling fluid and, in one or each of the side walls, a plurality of orifices through which pressurised cooling fluid is directed towards components of an adjacent circuit board of the installation.

The orifices in one or each side wall may each be a simple hole or, in some circumstances, in each of at least some of the orifices in one or each side wall a nipple may be inserted for directing a jet or spray of cooling fluid in a particular direction. The positions of the plurality of orifices in one or each side wall of the cooling module are conveniently determined by use of grid markings similar to those on a standard card employed to determine the positions of components on an adjacent circuit board.

Preferably, the or each inlet port is located at the rear edge of the cooling module and a self-sealing connector may be secured in the inlet port.

The source of pressurised cooling fluid may be housed in the enclosure of the circuit board installation but, preferably, it is positioned externally of the enclosure. The cooling fluid may be maintained at any desired pressure, temperature and humidity. As the cooling fluid, it is preferred to employ compressed air or any other gas that will not have any deleterious effect on the components and materials of the circuit boards.

If desired, the chamber of the substantially flat cooling module may be subdivided by internal barrier walls into a plurality of interconnecting passages through which pressurised cooling fluid is caused to flow and, in the region of each of at least some of the orifices in one or each side wall, the cross-sectional area of the associated passage may reduce gradually so that cooling fluid is directed from the orifice at a substantial pressure.

The invention also includes, for use in a circuit board installation of the kind described, a substantially flat cooling module as hereinbefore described.

The invention is further illustrated by a description, by way of example, of a preferred circuit board installation of the kind described with reference to the accompanying diagrammatic drawings, in which:-

Figure 1 is an exploded perspective view of a preferred substantially flat cooling module of the circuit board installation, and

Figure 2 is a fragmental sectional end view of the cooling module shown in Figure 1 looking in the direction of arrow A and two adjacent circuit boards of the circuit board installation.

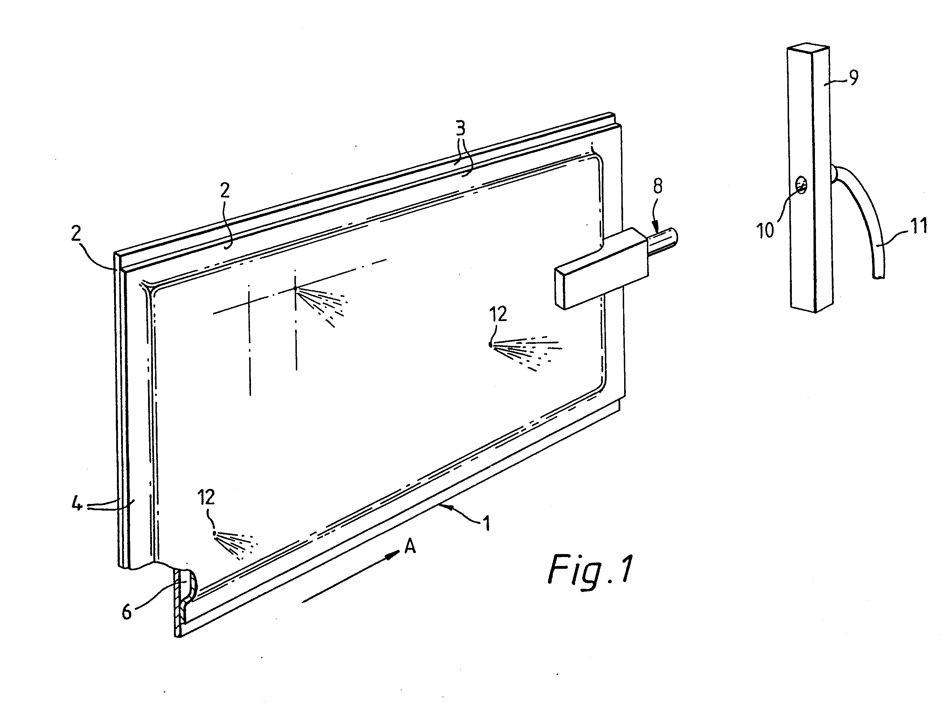

Referring to the drawings, the substantially flat cooling module 1 shown in Figure 1 comprises two rectangular side panels 2 which, over a major proportion of their surface areas between longitudinally extending marginal portions 3 and transversely extending marginal portions 4 are recessed in such a way that when the two panels are sealed together along their marginal portions, they define between them a chamber 6. As will be seen, major portions of the external surfaces of the panels 2 are substantially flat. A self-sealing connector 8 is secured to the rear end of the module 1 and provides an inlet port to the chamber 6. When the cooling module 1 is mounted in the cabinet of a circuit

**0091733**

board installation, the self-sealing connector 8 will pass through an aperture 10 in a vertical tie bar 9 at the rear of the cabinet for connection to an air hose 11 extending to a source of compressed air (not shown).

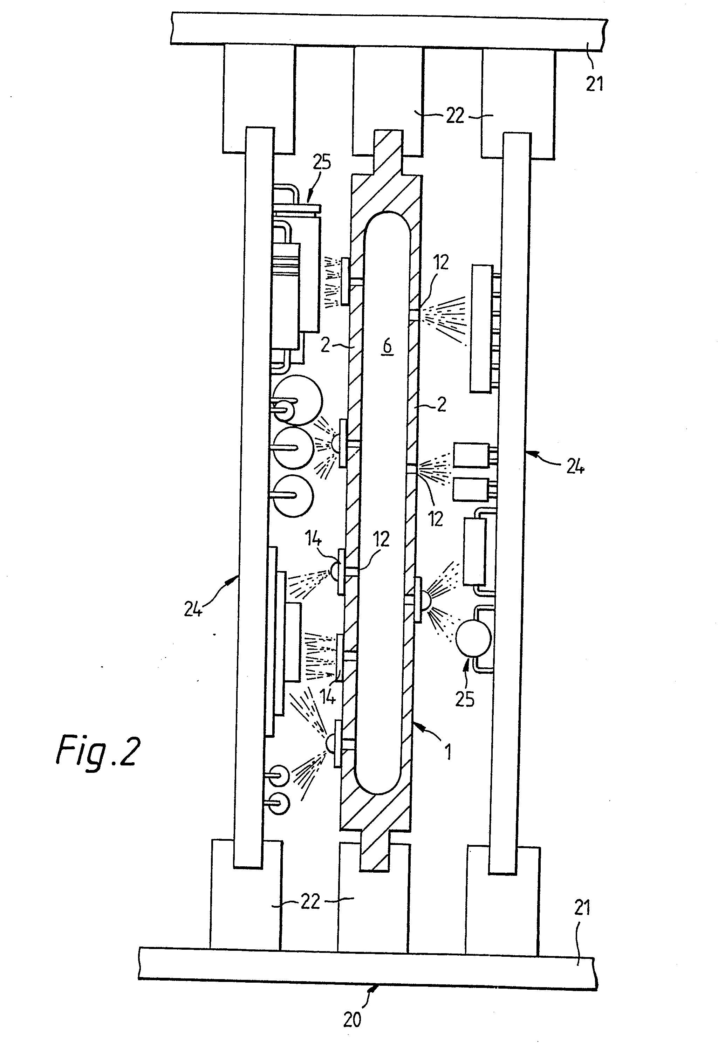

Each panel 2 has a plurality of orifices 12 through which compressed air introduced through the self-sealing connector 8 into the sealed chamber 6 can be directed towards components of an adjacent circuit board, the positions of the orifices in each panel having been determined by use of grid markings similar to those on a standard card employed to determine the positions of components of an adjacent circuit board.  As will be seen on referring to Figure 2, each of some of the orifices 12 may have fitted in it a nipple 14 for directing a jet or spray of compressed air in a particular direction.


In the circuit board installation shown in Figure 2, circuit boards 24 carrying components generally indicated by the reference 25 are slidably engaged in opposed upper and lower guide rails 22 of a rack 21 mounted in a cabinet 20.  Positioned between the circuit boards 24 and slidably engaged in upper and lower guide rails 22 of the rack 21 is a cooling module 1 of the kind shown in Figure 1.  Compressed air introduced into the sealed chamber 6 of the cooling module 1 through the self-sealing connector 8 is directed through the orifices 12 in each side panel 2 and, when present,

6

through nipples 14 fitted in some of the orifices, towards components 25 of each circuit board 24 to ensure that the components of the circuit board installation are not subjected to an undesirable high temperature.

The improved cooling system of the circuit board installation is effective and avoids unnecessary wastage of space within the cabinet of the installation.

CLAIMS:

1. A circuit board installation comprising a cabinet or other enclosure including at least one rack accommodating circuit boards, wherein at least one substantially flat cooling module is slidably mounted in opposed guide rails of the rack adjacent a circuit board or circuit boards, which cooling module comprises a pair of substantially flat side walls spaced apart and sealed together around their peripheral edges to form a sealed chamber, at least one inlet port connected or adapted to be connected to a source of pressurised cooling fluid and, in one or each of the side walls, a plurality of orifices through which pressurised cooling fluid is directed towards components of an adjacent circuit board of the installation.

2. A circuit board installation as claimed in Claim 1, wherein the positions of at least some of the plurality of orifices in one or each side wall of the cooling module substantially correspond to the positions of components on an adjacent circuit board.

3. A circuit board installation as claimed in Claim 1 or 2, wherein, in each of at least some of the orifices in one or each side wall of the cooling module, a nipple is inserted for directing a jet or spray of pressurised cooling fluid in a particular direction.

4.      A circuit board installation as claimed in any one of the preceding Claims, wherein the or each inlet port is located at the rear edge of the cooling module.

5.      A circuit board installation as claimed in any one of the preceding Claims, wherein a self-sealing connector is secured in the or each inlet port.

6.      A circuit board installation as claimed in any one of the preceding Claims, wherein the source of pressurised cooling fluid is housed externally of the cabinet or other enclosure.

7.      A circuit board installation as claimed in any one of the preceding Claims, wherein the cooling fluid is compressed air or any other gas that will not have any deleterious effect on the components and materials of the circuit boards.

8.      A circuit board installation as claimed in any one of the preceding Claims, wherein the chamber of the cooling module is sub-divided by internal barrier walls into a plurality of inter-connecting passages through which pressurised cooling fluid is caused to flow.

9.     A circuit board installation as claimed in Claim 8, wherein, in the region of each of at least some of the orifices in one or each side wall, the cross-sectional area of the associated passage reduces gradually so that cooling fluid is directed from the orifice at a substantial pressure.

10.     For use in a circuit board installation as claimed in any one of the preceding Claims, a substantially flat cooling module comprising a pair of substantially flat side walls spaced apart and sealed together around their peripheral edges to form a sealed chamber, at least one inlet port in the cooling module adapted to be connected to a source of pressurised cooling fluid and, in one or each of the side walls, a plurality of orifices through which pressurised cooling fluid can be directed towards components of an adjacent circuit board.

Fig.1

Fig.2

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| Y | DE-A-2 015 361 (SIEMENS AG) <br><br> * Page 2, paragraph 4 - page 3, paragraph 4; page 3, last paragraph - page 4, paragraph 3; figure 1 * <br><br> --- | 1,2,5-7,9 | H 05 K 7/20 |
| Y | DE-A-1 908 825 (SIEMENS AG) <br><br> * Page 2, paragraph 3 - page 3, paragraph 2; page 4, last paragraph - page 5, paragraph 2; page 5, paragraph 3 - page 9, paragraph 2; figures 8,9 * <br><br> --- | 1,2,4-7,10 | |
| A | DE-A-1 947 586 (SIEMENS AG) <br><br> --- | | **TECHNICAL FIELDS SEARCHED (Int. Cl. 3)** <br><br> H 05 K <br> H 01 L |
| A | IBM TECHNICAL DISCOSURE BULLETIN, vol. 20, no. 8, January 1978, page 3121, New York, USA <br> A.H. JOHNSON: "Diaphragm cooling for devices" <br><br> ----- | | |

The present search report has been drawn up for all claims

| Place of search <br> THE HAGUE | Date of completion of the search <br> 21-06-1983 | Examiner <br> SCHUERMANS N.F.G. |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82